Europäisches Patentamt

European Patent Office

Office européen des brevets

(19)

(11) Veröffentlichungsnummer: **0 019 140**
**B1**

(12) # EUROPÄISCHE PATENTSCHRIFT

(45) Veröffentlichungstag der Patentschrift:
04.01.84

(51) Int. Cl.³: **E 06 B 9/10**

(21) Anmeldenummer: 80102303.7

(22) Anmeldetag: 29.04.80

(54) Rolladen, insbesondere für Möbel.

(30) Priorität: 10.05.79 DE 7913550 U

(43) Veröffentlichungstag der Anmeldung:
26.11.80 Patentblatt 80/24

(45) Bekanntmachung des Hinweises auf die Patenterteilung:
04.01.84 Patentblatt 84/1

(84) Benannte Vertragsstaaten:
AT BE CH FR IT LI NL SE

(56) Entgegenhaltungen:
CH - A - 404 903
DE - A - 2 421 244
FR - A - 1 476 032
FR - A - 2 431 021

(73) Patentinhaber: METZELER SCHAUM GMBH,
Donaustrasse 51, D-8940 Memmingen (DE)

(72) Erfinder: Born, Eberhard, Im Oberiddelsfeld 7,
D-5000 Köln 80 (DE)
Erfinder: Kratochwil, Dietmar, Behringerstrasse 5,
D-8940 Memmingen (DE)
Erfinder: Maslock, Heinz, Nachtigallenweg 37,
D-7970 Leitkirch (DE)

(74) Vertreter: Michelis, Theodor, Dipl.-Ing.,
Gneisenaustrasse 15, D-8000 München 50 (DE)

## Rolladen, insbesondere für Möbel

Die Erfindung betrifft einen Rolladen, insbesondere für Möbel, bestehend aus einer rollfähigen Schichtstoffplatte, vorzugsweise aus Tacon, als Sichtseite und einer rückwärtigen Folie aus thermoplastischem Material, die mit Versteifungsprägungen versehen ist, wobei die Prägungen als Versteifungsrippen mit angenähert trapezförmigem Querschnitt ausgebildet sind und sich nur über eine solche Breite erstrecken, dass seitlich der Prägungen flache, ebene Streifen als Führungsbahnen für den Rolladen gebildet sind und zwischen der Schichtstoffplatte und der rückseitigen Folie eine Schicht aus einem weicherem Material angeordnet ist.

Ein derartiger Rolladen ist aus der FR-A-1 476 032 bekannt. Dabei wird dieser Rolladen so hergestellt, dass auf eine ebene Folie, die als Sichtseite dient, eine Schaumstoffschicht aufgelegt und anschliessend mit einer weiteren Folie abgedeckt ist, die anschliessend über eine Prägewalze mit Prägungen derart versehen wird, dass die über die gesamte Breite durchgehend geprägten Bereiche praktisch mit der vorderen, als Sichtseite dienenden Folie in Berührung kommen, was bedeutet, dass der dazwischenliegende Schaumstoff in diesen Bereichen vollständig zusammengepresst ist. Bei einem derartigen Rolladen, bei dem die Prägungen auf der Rückseite als Versteifungsrippen wirken, ist zwar eine ausreichende Festigkeit und Querversteifung gegeben, Schwierigkeiten können sich jedoch beim Aufrollen dieses Rolladens ergeben, da hierbei die Verbindungsstellen zwischen den beiden Folien besonders stark beansprucht wird, da durch die beim Aufrollen entstehenden Schiebebeanspruchungen sich diese beiden, miteinander verbundenen Folien wieder lösen können. Das bedingt eine erhebliche Verminderung der Haltbarkeit und der Lebensdauer eines solchen Rolladens.

Darüber hinaus ist aus der CH-A-404 903 eine aufrollbare Abschlusswand für Schränke bekannt, bei der auf der Rückseite der Rolladen-Sichtseite eine Schicht aus Gummi oder einem anderen gummielastischen Material, in das ein Textilgewebe eingebettet oder einvulkanisiert ist, befestigt, wobei auf diesem Belag noch parallel zueinander verlaufende Profilstäbe zur Querversteifung festgeklebt sind. Dieser elastische Belag soll dabei lediglich ein Dehnen der Wandung in Längsrichtung und damit ein Reissen verhindern.

Demgegenüber liegt der vorliegenden Erfindung die Aufgabe zugrunde einen Rolladen zu schaffen, der eine besonders gute Beweglichkeit und dabei lange Haltbarkeit aufweist, ohne dass die beim Aufrollen auftretenden Spannungen zu Schäden oder zu einem Ablösen einer der beiden Schichten des Folienmaterials führen.

Zur Lösung dieser Aufgabe ist erfindungsgemäss vorgesehen, dass zwischen der ebenen Schichtstoffplatte und der rückseitigen, mit hohlen, unverfüllten Versteifungsprägungen versehenen Verstärkungsfolie eine elastische Bahn aus Schaumstoff als ebene, unverpresste Zwischenschicht eingeklebt ist.

Bei einem derartigen Rolladen aus zwei parallelen, durchgehenden Schichten, die miteinander verklebt sind, können sich diese beiden Schichten bei einer Verwölbung um einen bestimmten Radius — d.h. beim Aufrollen des Rolladens — gegeneinander verspannen, da die innenliegende Versteifungsfolie auf einem kleineren Radius liegt als die äussere Schichtstoffplatte, wobei erhebliche Schubspannungen auftreten. Wenn nun zwischen diese beiden Schichten nach der Erfindung eine elastische, unverpresste Bahn aus Schaumstoff als Zwischenschicht eingeklebt ist, wird die Biegelinie des gesamten Rolladens beim Aufrollen in diese Schaumstoffschicht gelegt, wodurch die vorstehend beschriebenen Spannungen in der Verbindungsfläche zwischen den beiden Platten aufgenommen werden und ausserdem wird ein gewisser Längenausgleich für die innenliegende Schicht auf kleinerem Radius ermöglicht. Dieser Längenausgleich wird auch durch die trapezförmigen Prägungen der Verstärkungsfolie erreicht, da sich somit die Verstärkungsfolie leichter in ihrer Gesamtlänge verändern kann.

Anhand einer schematischen Zeichnung sind Aufbau und Wirkungsweise eines Ausführungsbeispiels nach der Erfindung näher erläutert. Dabei zeigen:

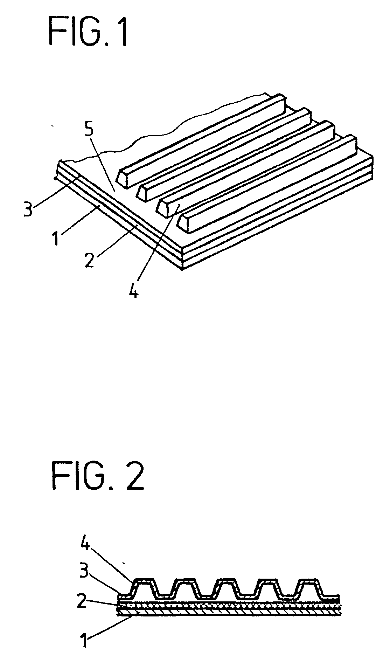

Fig. 1 eine ausschnittsweise perspektivische Darstellung eines Endes eines Rolladens von der Rückseite her und

Fig. 2 einen entsprechenden Längsschnitt durch den Rolladen nach Fig. 1.

In der Zeichnung ist mit 1 jeweils die rollfähige Schichtstoffplatte (Tacon), deren dekorative Seite die Sichtseite des Rolladens darstellt, bezeichnet. Auf die Rückseite dieser Schichtstoffplatte 1 ist zunächst eine Schaumstoffschicht 2 aufgeklebt, die wiederum auf ihrer Rückseite die geprägte Verstärkungsfolie 3 trägt.

Diese Verstärkungsfolie 3 aus thermoplastischem Material weist entsprechende Prägungen 4 als Querversteifungen auf, die beispielsweise als im Querschnitt trapezförmige Rippen ausgebildet sein können und sich angenähert über die gesamte Breite des Rolladens erstrecken. Lediglich seitlich der Prägung 4 können flache, ebene Streifen 5 freibleiben, die als Führung des Rolladens 1 in entsprechenden Nuten der abzuschliessenden Möbelstücke laufen. Es ist aber auch möglich, dass sich diese Prägungen 4 über die gesamte Breite erstrecken und dann mit in den Führungsnuten laufen.

Diese Prägungen können dabei beliebigen Querschnitt und beliebige Breite aufweisen. Es ist lediglich sicherzustellen, dass die erforderliche Querstefigkeit des Rolladens sichergestellt ist, um eine Durchbiegung oder ein Ausbeulen dieses Rolladens zu vermeiden.

Aus Fertigungsgründen empfiehlt es sich jedoch, als Verstärkungsfolie eine solche aus thermoplastischem Material zu wählen, da ein derartiges Material mit dem Schaumstoff mit einem Heiss- oder auch einem Kaltkleber leicht dauerhaft verbunden werden kann.

## Patentanspruch

Rolladen, insbesondere für Möbel, bestehend aus einer rollfähigen Schichtstoffplatte (1), vorzugsweise aus Tacon, als Sichtseite und einer rückseitigen Folie (3) aus thermoplastischem Material, die mit Versteifungsprägungen (4) versehen ist, wobei die Prägungen (4) als Versteifungsrippen mit angenähert trapezförmigem Querschnitt ausgebildet sind und sich nur über eine solche Breite erstrecken, dass seitlich der Prägungen (4) flache, ebene Streifen (5) als Führungsbahnen für den Rolladen (1) gebildet sind, und zwischen der Schichtstoffplatte (1) und der rückseitigen Folie (3) eine Schicht (2) aus einem weicheren Material angeordnet ist, dadurch gekennzeichnet, dass zwischen der ebenen Schichtstoffplatte (1) und der rückseitigen, mit hohlen, unverfüllten Versteifungsprägungen (4) versehenen Verstärkungsfolie (3) eine elastische Bahn aus Schaumstoff als ebene, unverpresste Zwischenschicht (2) eingeklebt ist.

## Claim

A roller shutter particularly for furniture, consisting of a rollable laminated panel (1), preferably made of Tacon, as visible surface, and a sheet (3) of thermoplastic material on the reverse side, comprising reinforced embossings (4), said embossings (4) are formed as stiffening ribs having an approximate trapezoidal cross section and extend only over such a width that at the lateral edges of the embossings (4) flat level strips (5) are formed as guide paths for the roller shutter (1), and between the laminated panel (1) and the sheet (3) on the reverse side is arranged a layer (2) of more soft material, characterised in that between the flat laminated panel (1) and the stiffening sheet (3) on the reverse side, comprising hollow, non filled reinforced embossings (4), there is pasted in an elastic sheet of foamed plastic as flat, unpressed intermediate layer.

## Revendication

Rideau, notamment pour meuble, constitué d'une plaque stratifiée (1), susceptible d'être enroulée, de préférence en Tacon, servant de face visible et d'une feuille postérieure (3) en matière thermoplastique, qui est munie d'empreintes (4), lesdites empreintes étant réalisées sous la forme de nervures de renforcement à section transversale sensiblement trapézoïdale et ne s'étendant que sur une largeur telle que des bandes (5) plates et planes, servant de voies de guidage pour le rideau, soient formées latéralement par rapport aux empreintes (4), une couche (2) en un matériau plus mou étant interposée entre la plaque stratifiée (1) et la feuille postérieure (3), caractérisé en ce qu'entre la plaque stratifiée (1) plane et la feuille de renforcement (3) munie d'empreintes de renforcement creuses, non remplies, est interposée, à titre de couche intermédiaire plane non comprimée (2), une bande élastique en matière mousse.

FIG. 1

FIG. 2